# EUROPÄISCHE PATENTSCHRIFT

(11) **EP 2 051 090 B1**
(45) Veröffentlichungstag und Bekanntmachung des Hinweises auf die Patenterteilung: **04.01.2012**
(21) Anmeldenummer: 08166700.8
(22) Anmeldetag: 15.10.2008
(51) Int. Cl.: G01R 33/09, G01R 33/14

(54) **Sonde für ein Magnet-Remanenz-Messverfahren und Verfahren zur Detektion von Fremdmaterialablagerungen und Einschlüssen in Hohlräumen**
Probe for a magnetic remanence measuring procedure and method of detecting impure accumulations and inclusions in hollow spaces
Sonde pour un procédé de mesure à résonance magnétique et procédé de détection de dépôts d'impuretés et d'inclusions dans des chambres creuses

(30) Priorität: 19.10.2007 DE 102007050143
(43) Veröffentlichungstag der Anmeldung: 22.04.2009
(73) Patentinhaber: MTU Aero Engines GmbH, 80995 München (DE)
(72) Erfinder: Feist, Wolf-Dieter, 85256, Vierkirchen (DE); Hinken, Johann, 39114, Magdeburg (DE); Beller, Thomas, 39114, Magdeburg (DE); Ziep, Christian, 39326, Samswegen (DE)

(56) Entgegenhaltungen:
- DE-A1- 4 126 810
- US-A- 5 121 058
- US-B1- 6 407 545

## Beschreibung

Die vorliegende Erfindung betrifft eine Sonde für ein Magnet-Remanenz-Messverfahren, insbesondere zur Detektion von Fremdmaterialablagerungen und Einschlüssen in Hohlräumen, wobei die Sonde mindestens einen Magnetfeldsensor aufweist. Die Erfindung betrifft weiterhin ein Verfahren zur Detektion von Fremdmaterialablagerungen und Einschlüssen in Hohlräumen.

Bei einer Vielzahl von technischen Anwendungen verursachen ferromagnetische Einschlüsse, die sich in einer nicht-ferromagnetischen Umgebung befinden, erhebliche Probleme. So können zum Beispiel kleinste Fremdmaterialablagerungen oder Einschlüsse in Bauteilen von Flugtriebwerken zu erheblichen Beschädigungen dieser führen. Entsprechende Fremdmaterialablagerungen und Einschlüsse können zum Beispiel durch Schneidstoffreste, die durch Schneidkantenbrüche oder -ausbrüche bei Bohrwerkzeugen entstehen, sein. Derartige Einschlüsse führen zu Defekten im Bereich der Oberfläche der entsprechenden Bauteile, ohne dass diese ohne Weiteres erkennbar sind. Besondere Relevanz erhalten diese Fremdmaterialablagerungen und Einschlüsse dann, wenn es sich um Bohrungen handelt, da diese ein erhöhtes Spannungsniveau haben und auch nur sehr schwer zugänglich sind. Zur Detektion von Fremdmaterialablagerungen und Einschlüssen in Hohlräumen, insbesondere in Bohrungen von Turbinen- und Verdichterwerkstoffen von Flugtriebwerken sind auf Ferromagnetismus beruhende, zerstörungsfreie Prüfverfahren beschrieben worden. Diese Verfahren sind anwendbar, da es sich bei den von dem Bohrwerkzeug abgesplitterten Materialien um ferromagnetisches Hartmetall handelt, wohingegen Turbinen- und Verdichterwerkstoffe nicht ferromagnetisch sind. Insbesondere wurde die magnetische Remanenzmethode wie auch die so genannte Wirbelstrommethode beschrieben und verwendet, um kleine ferromagnetische Teilchen in einer nicht-ferromagnetischen Umgebung zu detektieren. Allerdings weisen diese beiden Verfahren bei der Detektion, Ortsbestimmung und Charakterisierung ferromagnetischer Einschlüsse in Hohlräumen verschiedene Nachteile auf. So kann die magnetische Remanenzmethode bisher nur zur Detektion von Fremdmaterialablagerungen und Einschlüssen an der Bauteiloberfläche erfolgen. Dagegen weisen Hohlraumuntersuchungen mit dem Wirbelstromverfahren den Nachteil auf, dass eine Trennung zwischen ferromagnetischen Einschlüssen und geometrischen Anomalien nur bedingt möglich ist.

Das Dokument US 6 407 545 B1 schützt ein Gerät und ein Verfahren zum Messen der magnetischen Eigenschaften eines magnetischen Aufnahme- bzw. Speichermaterials. Das Gerät umfasst eine Magnetisiereinheit zum Erzeugen eines gepulsten Magnetfelds. Es umfasst weiter eine Messeinheit zum Erfassen der magnetischen Remanenz des Aufnahmematerials. Das Gerät umfasst schließlich noch eine Erfassungseinheit für den Sättigungszustand der Remanenz. Das Gerät weist zwei Elektromagneten in Form von elektrischen Spulen und mindestens einen Magnetfeldsensor auf und bildet somit auch eine Sonde für ein Magnet-Remanenz-Messverfahren.

Das Dokument DE 41 26 810 A1 offenbart ein Verfahren sowie eine Anordnung zur Messung der Remanenz eines aus einem ferromagnetischen Werkstoff bestehenden Bauteils für eine zerstörungsfreie Werkstoffprüfimg. Der Prüfkopf, d.h. die Sonde, weist eine Magnetisierungsspule, eine Entmagnetisierungsspule und eine Messspule auf, wobei letztere mit einer Auswerteinheit verbunden ist.

Es ist daher Aufgabe der vorliegenden Erfindung eine gattungsgemäße Sonde für ein Magnet-Remanenz-Messverfahren bereitzustellen, die eine zuverlässige Detektion und Ortsbestimmung von ferromagnetischen Fremdmaterialablagerungen und Einschlüssen in Hohlräumen ermöglicht.

Es ist weiterhin Aufgabe der vorliegenden Erfindung ein gattungsgemäßes Verfahren zur Detektion von Fremdmaterialablagerungen und Einschlüssen in Hohlräumen bereitzustellen, welches eine zuverlässige Detektion und Ortsbestimmung von ferromagnetischen Fremdmaterialablagerungen und Einschlüssen gewährleistet.

Gelöst werden diese Aufgaben durch eine Sonde gemäß den Merkmalen des Anspruchs 1 sowie ein Verfahren gemäß den Merkmalen des Anspruchs 10.

Vorteilhafte Ausgestaltungen der Erfindung sind in den jeweiligen Unteransprüchen beschrieben.

Eine erfindurtgsgemäße Sonde für ein Magnet-Remanenz-Verfahren, zur Detektion von Fremdmaterialablagerungen und Einschlüssen in Hohlräumen, wobei die Hohlräume in einem nicht-ferromagnetischen Werkstoff ausgebildet sind und die Fremdmaterialablagerangen und Einschlüsse aus einem ferromagnetischen Material bestehen, weist mindestens einen Magnetfeldsensor auf, der zum Messen der als magnetische Remanenz messbaren Signaturen der Magnetfelder der Fremdmaterialablagerungen und -einschlüsse ausgebildet ist. Zudem umfasst die Sonde mindestens einen ersten und einen zweiten Magneten, wobei die Magnete in einer Einführrichtung in den Hohlraum vor dem mindestens einen Magnetfeldsensor ausgebildet sind und derart zueinander angeordnet sind, dass ihre Polachsen nicht-parallel zueinander verlaufen. Durch die Anordnung von zwei Magneten mit unterschiedlich verlaufenden Polachsen ergibt sich eine Aufinagnetisierung der ferromagnetischen Fremdmaterialablagerungen und Einschlüsse in unterschiedliche Richtungen, so dass die Hauptausrichtung des Fremdmaterialpartikels oder des Einschlusses zuverlässig dargestellt werden kann. Vorteilhafterweise gewährleistet die erfindungsgemäße Sonde eine zuverlässige Detektion und Ortsbestimmung von ferromagnetischen Fremdmaterialablagerungen und Einschlüssen in Hohlräumen. Gemäß einer Ausführungsform der erfindungsgemäßen Sonde können dabei die Polachsen der ersten und zweiten Magnete senkrecht zueinander angeordnet sein.

In weiteren vorteilhaften Ausgestaltungen der erfindungsgemäßen Sonde ist der Magnetfeldsensor und die Magnete auf einem Basiselement angeordnet. Dabei ist die Sonde vorteilhafterweise derart ausgebildet, dass sie in Hohlräume mit einem Durchmesser zwischen 2 mm und 100 mm, insbesondere zwischen 2 mm und 10 mm einführbar ist. Durch die Miniaturisierung der Sonde ist es möglich, dass auch Hohlräume mit sehr kleinem Durchmesser, wie zum Beispiel durch Bohrungen entstandene Hohlräume analysiert werden können.

In einer weiteren vorteilhaften Ausgestaltung der erfindungsgemäßen Sonde weist diese einen ersten und einen zweiten Magnetfeldsensor auf, wobei der erste Magnetfeldsensor zur Detektion einer durch den ersten Magneten verursachten magnetischen Remanenz und der zweite Magnetfeldsensor zur Detektion einer durch den zweiten Magneten verursachten magnetischen Remanenz ausgebildet ist. Dabei können der erste Magnet zwischen dem ersten Magnetfeldsensor und dem zweiten Magnetfeldsensor und der zweite Magnet in Einführrichtung der Sonde in den Hohlraum vor dem zweiten Magnetfeldsensor angeordnet sein. Durch die Zuordnung von jeweils einem Magnetfeldsensor zu einem Magneten ist es möglich, dass magnetische Remanenzen, die durch das Verfahren der Sonde in dem Hohlraum entstehen, sofort durch den entsprechenden Magnetfeldsensor detektiert werden. Dadurch können auch Einschlüsse mit geringen Durchmessern zuverlässig ermittelt werden.

In weiteren vorteilhaften Ausgestaltungen der erfindungsgemäßen Sonde sind der erste und der zweite Magnetfeldsensor so genannte GMR-Sensoren ("Giant Magneto Resistance-Sensor") oder so genannte AMR-Sensoren ("Anisotropic Magneto Resistance-Sensor"). Derartige Sensoren haben den Vorteil, dass sie üblicherweise klein dimensioniert sind und in ihren Ausfuhrungsibnnen als Gradiometer gegenüber magnetischen Hintergrundsignalen relativ unempfindlich sind. Es können daher extrem schwache Magnetfelder, wie sie durch die magnetische Remanenz der Fremdmaterialablagerungen und Einschlüsse entstehen, gemessen werden.

In einer weiteren vorteilhaften Ausgestaltung der erfindungsgemäßen Sonde sind der oder die Magnetfeldsensoren mit einer Auswerteeinheit verbunden. Dadurch ist es möglich, die ermittelten Messwerte zum Beispiel grafisch darzustellen, so dass neben der Anzahl der detektierten Fremdmaterialablagerungen und Einschlüsse auch deren Anzahl und Position im Hohlraum bzw. in dem den Hohlraum umgebenden Werkstoff exakt bestimmt und dargestellt werden kann.

In einer weiteren vorteilhaften Ausgestaltung der erfindungsgemäßen Sonde ist der nicht-ferromagnetische Werkstoff eine Nickelbasis- oder Titan-Legierung. Ferromagnetische Fremdmaterialablagerungen und Einschlüsse bestehen aus Hartmetall, insbesondere Wolframcarbid. Die genannten nicht-ferromagnetischen Werkstoffe werden insbesondere zur Herstellung von Bauteilen von Verdichtern und Turbinen von Flugtriebwerken verwendet. Die genannten ferromagnetischen Fremdmaterialablagerungen und Einschlüsse entstehen beim Absplittern von Teilen eines Bohrwerkzeugs bei der Herstellung von Bohrungen in die genannten Bauteile der Flugtriebwerke.

Ein erfindungsgemäßes Verfahren zur Detektion von Fremdmaterialablagerungen und Einschlüssen in Hohlräumen weist folgende Schritte auf: a) Einfahren einer Sonde in einen Hohlraum in einem nicht-ferromagnetischen Werkstoff, wobei die Sonde mindestens einen Magnetfeldsensor und mindestens einen ersten und einen weiten Magneten umfasst, wobei die Magnete in Einführrichtung in den Hohlraum vor mindestens einem Magnetfeldsensor ausgebildet sind und derart zueinander angeordnet sind, dass ihre Polachsen nicht-parallel zueinander verlaufen: b) Magnetisierung von Fremdmaterialablagerungen und Einschlüssen aus einem ferromagnetischen Material mittels der Magnete; c) Messen der durch die Magnetisierung entstandenen und nach einem Weiterverfahren der Magnete als magnetische Remanenz messbaren Signaturen der Magnetfelder der Fremdmaterialablagerungen und Einschlüsse mittels des Magnetfeldsensors; und d) Auswertung der gemessenen Magnetfelddaten und Darstellung der Anzahl und Position der Fremdmaterialablagerungen und Einschlüsse in dem Hohlraum. Durch die Aufinagneüsierung der ferromagnetischen Fremdmaterialpartikel und/oder Einschlüsse in verschiedene Richtungen ist es möglich, die Hauptausrichtung des Partikels oder des Einschlusses exakt zu bestimmen. Es ist somit eine zuverlässige Detektion und Ortsbestimmung von ferromagnetischen Fremdmaterialablagerungen und/oder Einschlüssen gewährleistet.

In einer vorteilhaften Ausgestaltung des erfindungsgemäßen Verfahrens weist die Sonde einen ersten und einen zweiten Magnetfeldsensor auf, wobei der erste Magnetfeldsensor zur Detektion einer durch den ersten Magneten verursachten magnetischen Remanenz und der zweite Magnetfeldsensor zur Detektion einer durch den zweiten Magneten verursachten magnetischen Remanenz ausgebildet ist. Der erste Magnet kann dabei zwischen dem ersten Magnetfeldsensor und dem zweiten Magnetfeldsensor und der zweite Magnet in Einführrichtung der Sonde in den Hohlraum vor dem zweiten Magnetfeldsensor angeordnet sein. Zudem können die Polachsen des ersten und zweiten Magneten senkrecht zueinander angeordnet sein. Eine derartige Anordnung gewährleistet, dass auch kleinste ferromagnetische Fremdmaterialablagerungen und Einschlüsse zuverlässig detektiert werden können, da die Magnetfeldsensoren unmittelbar nach der Aufmagnetisierung dieser Partikel und Einschlüsse das durch die magnetische Remanenz erzeugte Magnetfeld messen. Insbesondere sind auch eine exakte Größen- und Ortsbestimmung der Partikel und Einschlüsse möglich. auch Spätschäden, wie zum Beispiel Rissbildungen in den entsprechenden Triebwerksbauteilen.

In vorteilhafter Ausgestaltung weid die Sonde innerhalb des Höhlraums linear verfahren.

Der Magnetfeldsensor bzw. die Magnetfeldsensoren sind vorzugsweise Magnetfeldgradiometer.

Weitere Vorteile, Merkmale und Einzelheiten der Erfindung ergeben sich aus der nachfolgenden Beschreibung eines zeichnerisch dargestellten Ausführungsbeispiels. Es zeigen
- Figur 1: eine Darstellung einer erfindungsgemäßen Sonde für ein Magnet- Remanenz-Messverfahren; und
- Figur 2: einen Bildschirmausdruck eines Messergebnisses zweier GMR- Magnetfeldsensoren der Sonde gemäß Figur 1.

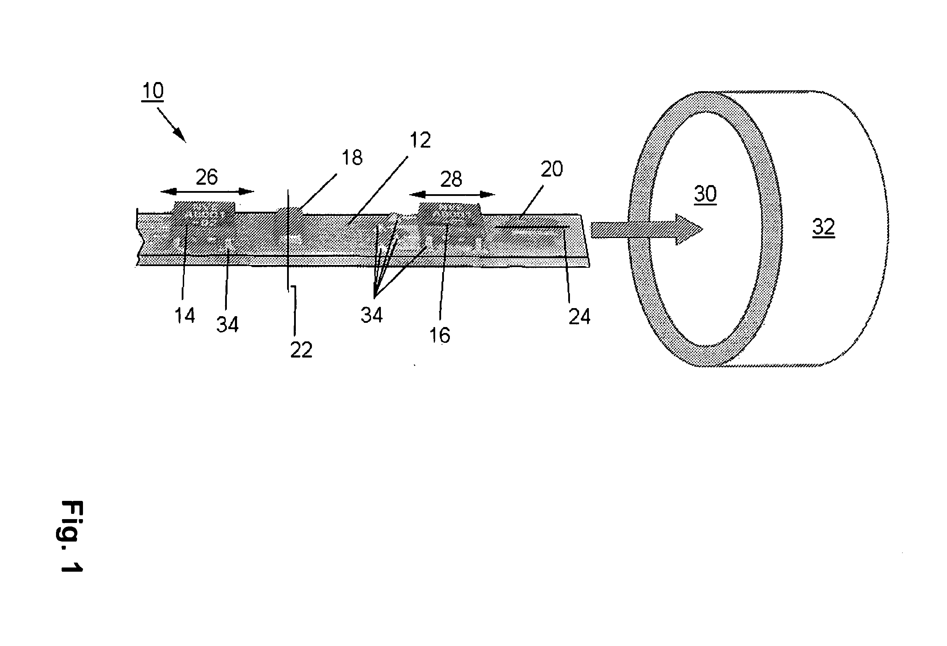

Figur 1 zeigt eine Sonde 10 zur Verwendung in einem Magnet-Remanenz-Messverfahren. Die Sonde 10 besteht dabei aus einem länglich ausgebildeten Basiselement 12, auf dem ein erster Magnet 18 und ein zweiter Magnet 20 sowie ein erster Magnetfeldsensor 14 und ein zweiter Magnetfeldsensor 16 angeordnet sind. Zudem sind auf dem Basiselement 12 verschiedene Anschlüsse 34 ausgebildet, wie zum Beispiel Anschlüsse für die Stromversorgung der Magnetfeldsensoren 14, 16, Anschlüsse für die Erdung der Magnetfeldsensoren 14, 16 wie auch Anschlüsse für die Datenübertragung der durch die Magnetfeldsensoren 14, 16 ermittelten Werte an eine Auswerteeinheit (nicht dargestellt). Man erkennt, dass in Einführrichtung des Sensors 10 in einen Hohlraum 30 eines aus nicht-ferromagnetischem Material bestehenden Bauteils 32 der zweite Magnet 20 vor dem zweiten Magnetfeldsensor 16 und der zweite Magnetfeldsensor 16 vor dem ersten Magneten 18 sowie der erste Magnetfeldsensor 14 hinter dem ersten Magneten 18 angeordnet ist. Dabei kann der Abstand zwischen dem zweiten Magneten 20 und dem zweiten Magnetfeldsensor 16 ca. 2 mm, der Abstand zwischen dem ersten Magneten 18 und dem ersten Magnetfeldsensor 14 ca. 3 mm und der Abstand zwischen den Magnetfeldsensoren 14, 16 ca. 15 mm betragen. In dem dargestellten Ausführungsbeispiel sind die Magnetfeldsensoren 14, 16 ca. 1,3 mm hoch. Die Magnete 18, 20 weisen eine Höhe von ca. 1 mm auf. Des Weiteren erkennt man, dass die Polachsen 22, 24 des ersten Magneten 18 und des zweiten Magneten 20 in unterschiedliche Richtungen verlaufen und in dem dargestellten Ausführungsbeispiel senkrecht zueinander verlaufen. Dabei ist die Polachse 24 des zweiten Magneten 20 senkrecht zu den Sensitivitätsachsen 26, 28 der Magnetfeldsensoren 14, 16 angeordnet. Die Polachse 22 des ersten Magneten 18 ist entsprechend parallel zu den Sensitivitätsachsen 26, 28 orientiert. Insgesamt ist die Sonde 10 derart dimensioniert ausgebildet, dass sie in einen Hohlraum 30 eingeführt werden kann, der einen Durchmesser zwischen 2 mm und 100 mm, insbesondere zwischen 2 mm und 10 mm aufweist. Der in dem Ausführungsbeispiel dargestellte Hohlraum 30 weist einen Durchmesser von ca. 7,2 mm auf. Das Basiselement 12 besteht aus einem nicht-ferromagnetischen Material.

Die in dem Ausführungsbeispiel verwendeten Magnetfeldsensoren 14, 16 sind so genannte GMR-Sensoren ("Giant Magneto Resistance-Sensoren"). Diese sind in der Lage sehr geringe Flussdichten bzw. Magnetfelder von magnetisierten, ferromagnetischen Fremdmaterialablagerungen und Einschlüssen zu detektieren.

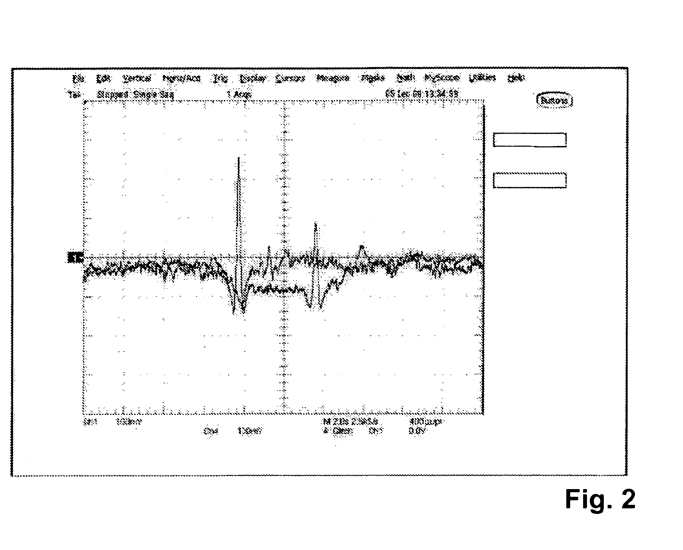

Figur 2 zeigt einen Bildschirmausdruck eines Messergebnisses der beiden GMR-Magnetfeldsensoren 14, 16 der gemäß dem in Figur 1 gezeigten Ausführungsbeispiel ausgebildeten Sonde 10. Es handelt sich dabei um einen Linienscan der beiden Magnetfeldsensoren 14, 16. Man erkennt deutlich die sich in bestimmten Bereichen der linearen Abtastung ergebenden Peaks relativ hoher magnetischer Flussdichte, die jeweils einen ferromagnetischen Einschluss in dem Hohlraum 30 darstellen. Es handelt sich um eine bipolare Darstellung, die Änderungen der magnetischen Flussdichte sind in Millivolt angegeben, sie sind proportional zur gemessenen magnetischen Flussdichte in Tesla angegeben (vergleiche mittig angeordnete vertikale Achse des Diagramms). Durch den dargestellten Linienscan wird deutlich, dass die Anordnung von zwei Magneten 18, 20, deren Polachsen 22, 24 unterschiedlich zueinander ausgerichtet sind, insbesondere senkrecht zueinander ausgerichtet sind, eine sehr genaue Detektion von Fremdmaterialablagerungen und Einschlüssen in Hohlräumen 30 sowohl hinsichtlich deren Anzahl wie auch Größe und Positionierung innerhalb des Hohlraums 30 ermöglicht.

## Patentansprüche

1. Sonde für ein Magnet-Remanenz-Messverfahren ausgebildet zur Detektion von Fremdmaterialablagerungen und Einschlüssen in Hohlräumen, wobei die Hohlräume (30) in einem nicht-ferromagnetischen Werkstoff (32) ausgebildet sind und die Fremdmaterialablagerungen und Einschlüsse aus einem ferromagnetischen Material bestehen, wobei die Sonde (10) mindestens einen Magnetfeldsensor (14,16) aufweist, wobei die Sonde (10) mindestens einen ersten und einen zweiten Magnet (18, 20) umfasst, wobei die Magnete (18, 20) in einer Einführrichtung in den Hohlraum (30) vor dem mindestens einen Magnetfeldsensor (14, 16) ausgebildet sind und derart zueinander angeordnet sind, dass ihre Polachsen (22, 24) nicht-parallel zueinander verlaufen und wobei der mindestens eine Magnetfeldsensor (14, 16) zum Messen der als magnetischen Remanenz messbaren Signaturen der Magnetfelder der Fremdmaterialablagerungen und -einschlüsse ausgebildet ist.

2. Sonde nach Anspruch 1, **dadurch gekennzeichnet, dass** der Magnetfeldsensor (14,16) und die Magnete (18, 20) auf einem Basiselement (12) angeordnet sind.

3. Sonde nach Anspruch 1 oder 2, **dadurch gekennzeichnet, dass** die Sonde (10) einen ersten und einen zweiten Magnetfeldsensor (14, 16) aufweist, wobei der erste Magnetfeldsensor (14) zur Detektion einer durch den ersten Magneten (18) verursachten magnetischen Remanenz und der zweite Magnetfeldsensor (16) zur Detektion einer durch den zweiten Magneten (20) verursachten magnetischen Remanenz ausgebildet ist.

4. Sonde nach Anspruch 3, **dadurch gekennzeichnet, dass** der erste Magnet (18) zwischen dem ersten Magnetfeldsensor (14) und dem zweiten Magnetfeldsensor (16) und der zweite Magnet (20) in Einführrichtung der Sonde (10) in den Hohlraum (38) vor dem zweiten Magnetfeldsensor (16) angeordnet ist.

5. Sonde nach einem der vorhergehenden Ansprüche, **dadurch gekennzeichnet, dass** die Sonde (10) derart ausgeführt ist, dass die Polachsen (22, 24) des ersten und des zweiten Magneten (18, 20) senkrecht zueinander angeordnet sind.

6. Sonde nach einem der vorhergehenden Ansprüche, **dadurch gekennzeichnet, dass** sie in Hohlräume (30) mit einem Durchmesser zwischen 2 mm und 100 mm, insbesondere zwischen 2 mm und 10 mm einführbar ist.

7. Sonde nach einem der vorhergehenden Ansprüche, **dadurch gekennzeichnet, dass** der erste und der zweite Magnetfeldsensor (14, 16) GMR-Sensoren, Giant MagnetoResistance -Sensor, oder AMR-Sensoren, Anisotropic Magneto-Resistance -Sensor, sind.

8. Sonde nach einem der vorhergehenden Ansprüche, **dadurch gekennzeichnet, dass** der oder die Magnetfeldsensoren (14, 16) mit einer Auswerteeinheit verbunden sind.

9. Sonde nach einem der vorhergehenden Ansprüche, **dadurch gekennzeichnet, dass** der nicht-ferromagnetische Werkstoff (32) eine Nickelbasis- oder Ti-Legierung ist und die ferromagnetischen Fremdmaterialablagerungen und Einschlüsse aus Hartmetall, insbesondere Wolframkarbid, bestehen.

10. Verfahren zur Detektion von Fremdmaterialablagerungen und Einschlüssen in Hohlräumen mit folgenden Schritten:
a) Einführen einer Sonde (10) in einen Hohlraum (30) in einem nicht-ferromagnetischen Werkstoff (32), wobei die Sonde (10) mindestens einen Magnetfeldsensor (14,16) und mindestens einen ersten und einen zweiten Magneten (18, 20) umfasst, wobei die Magnete (18, 20) in Einführrichtung in den Hohlraum (30) vor mindestens einem Magnetfeldsensor (14, 16) ausgebildet sind und derart zueinander angeordnet sind, dass ihre Polachsen (22, 24) nicht-parallel zueinander verlaufen;
b) Magnetisierung von Fremdmaterialablagerungen und Einschlüssen aus einem ferromagnetischen Material mittels der Magnete (18, 20);
c) Messen der durch die Magnetisierung entstandenen und nach einem Weiterverfahren der Magnete (18, 20) als magnetische Remanenz messbaren Signaturen der Magnetfelder der Fremdmaterialablagerungen und -einschlüsse mittels des Magnetfeldsensors (14, 16); und
d) Auswertung der gemessenen Magnetfelddaten und Darstellung der Anzahl und Position der Fremdmaterialablagerungen und -einschlüsse in dem Hohlraum (30).

11. Verfahren nach Anspruch 10, **dadurch gekennzeichnet, dass** die Sonde (10) einen ersten und einen zweiten Magnetfeldsensor (14, 16) aufweist, wobei der erste Magnetfeldsensor (14) zur Detektion einer durch den ersten Magneten (18) verursachten magnetischen Remanenz und der zweite Magnetfeldsensor (16) zur Detektion einer durch den zweiten Magneten (20) verursachten magnetischen Remanenz ausgebildet ist.

12. Verfahren nach Anspruch 11, **dadurch gekennzeichnet, dass** der erste Magnet (18) zwischen dem ersten Magnetfeldsensor (14) und dem zweiten Magnetfeldsensor (16) und der zweite Magnet (20) in Einführrichtung der Sonde (10) in den Hohlraum (38) vor dem zweiten Magnetfeldsensor (16) angeordnet ist.

13. Verfahren nach einem der Ansprüche 10 bis 12, **dadurch gekennzeichnet, dass** die Polachsen (22, 24) des ersten und zweiten Magneten (18, 20) senkrecht zueinander angeordnet sind.

14. Verfahren nach einem der Ansprüche 10 bis 13, **dadurch gekennzeichnet, dass** die Sonde (10) derart dimensioniert ist, dass sie in einen Hohlraum (30) mit einem Durchmesser zwischen 2 mm und 100 mm, insbesondere zwischen 2 mm und 10 mm einführbar ist.

15. Verfahren nach einem der Ansprüche 10 bis 14, **dadurch gekennzeichnet, dass** der erste und der zweite Magnetfeldsensor (14, 16) GMR-Sensoren, Giant MagnetoResistance"-Sensor, oder AMR-Sensoren, Anisotropic Magneto-Resistance-Sensor, sind.

16. Verfahren nach einem der Ansprüche 10 bis 15, **dadurch gekennzeichnet, dass** die Sonde (10) innerhalb des Hohlraums (30) gedreht wird.

17. Verwendung einer Sonde nach einem der Ansprüche 1 bis 9 oder eines Verfahrens nach einem der Ansprüche 10 bis 16 zur Detektion von Fremdmaterialablagerungen und Einschlüssen in Bohrungen in Bauteilen von Flugtriebwerken, insbesondere in Verdichter- und Turbinenbauteilen.

18. Verwendung einer Sonde nach Anspruch 17, **dadurch gekennzeichnet, dass** die Fremdmaterialablagerungen und -einschlüsse Absplitterungen von Bohrwerkzeugen aus ferromagnetischen Werkstoffen sind.

## Claims

1. A probe for a magnetic-remanence-measuring method formed for the detection of foreign-material accumulations and inclusions in hollow spaces, wherein the hollow spaces (30) are formed in a non-ferromagnetic material (32) and the foreign-material accumulations and inclusions consist of a ferromagnetic material, wherein the probe (10) has at least one magnetic-field sensor (14, 16), wherein the probe (10) comprises at least one first and one second magnet (18, 20), wherein the magnets (18, 20) are formed in front of the at least one magnetic-field sensor (14, 16) in a direction of insertion into the hollow space (30) and are arranged in relation to each other in such a way that their polar axes (22, 24) extend in a non-parallel manner with respect to each other, and wherein the at least one magnetic-field sensor (14, 16) is formed for the measurement of the signatures of the magnetic fields of the foreign-material accumulations and inclusions that can be measured as magnetic remanence.

2. A probe according to claim 1, **characterised in that** the magnetic-field sensor (14, 16) and the magnets (18, 20) are arranged on a base element (12).

3. A probe according to claim 1 or 2, **characterised in that** the probe (10) has a first and a second magnetic-field sensor (14, 16), wherein the first magnetic-field sensor (14) is formed for the detection of a magnetic remanence that is caused by the first magnet (18), and the second magnetic-field sensor (16) is formed for the detection of a magnetic remanence that is caused by the second magnet (20).

4. A probe according to claim 3, **characterised in that** the first magnet (18) is arranged between the first magnetic-field sensor (14) and the second magnetic-field sensor (16), and the second magnet (20) is arranged in front of the second magnetic-field sensor (16) in the direction of insertion of the probe (10) into the hollow space (38).

5. A probe according to one of the preceding claims, **characterised in that** the probe (10) is constructed in such a way that the polar axes (22, 24) of the first and the second magnet (18, 20) are arranged perpendicularly with respect to each other.

6. A probe according to one of the preceding claims, **characterised in that** it can be inserted into hollow spaces (30) with a diameter between 2 mm and 100 mm, in particular between 2 mm and 10 mm.

7. A probe according to one of the preceding claims, **characterised in that** the first and the second magnetic-field sensor (14, 16) are GMR sensors - giant magnetoresistance sensor - or AMR sensors - anisotropic magnetoresistance sensor.

8. A probe according to one of the preceding claims, **characterised in that** the magnetic-field sensor or sensors (14, 16) is/are connected to an evaluation unit.

9. A probe according to one of the preceding claims, **characterised in that** the non-ferromagnetic material (32) is a nickel-based or Ti alloy, and the ferromagnetic foreign-material accumulations and inclusions consist of hard metal, in particular tungsten carbide.

10. Method for the detection of foreign-material accumulations and inclusions in hollow spaces having the following steps:
a) insertion of a probe (10) into a hollow space (30) in a non-ferromagnetic material (32), wherein the probe (10) comprises at least one magnetic-field sensor (14, 16) and at least one first and one second magnet (18, 20), wherein the magnets (18, 20) are formed in front of at least one magnetic-field sensor (14, 16) in the direction of insertion into the hollow space (30) and are arranged in relation to each other in such a way that their polar axes (22, 24) extend in a non-parallel manner with respect to each other;
b) magnetization by means of the magnets (18, 20) of foreign-material accumulations and inclusions consisting of a ferromagnetic material;
c) measurement by means of the magnetic-field sensor (14, 16) of the signatures of the magnetic fields of the foreign-material accumulations and inclusions that have developed as a result of the magnetization and can be measured as magnetic remanence after a further movement of the magnets (18, 20); and
d) evaluation of the magnetic-field data measured and representation of the number and position of the foreign-material accumulations and inclusions in the hollow space (30).

11. Method according to claim 10, **characterised in that** the probe (10) has a first and a second magnetic-field sensor (14, 16), wherein the first magnetic-field sensor (14) is formed for the detection of a magnetic remanence that is caused by the first magnet (18), and the second magnetic-field sensor (16) is formed for the detection of a magnetic remanence that is caused by the second magnet (20).

12. Method according to claim 11, **characterised in that** the first magnet (18) is arranged between the first magnetic-field sensor (14) and the second magnetic-field sensor (16), and the second magnet (20) is arranged in front of the second magnetic-field sensor (16) in the direction of insertion of the probe (10) into the hollow space (38).

13. Method according to one of claims 10 to 12, **characterised in that** the polar axes (22, 24) of the first and second magnet (18, 20) are arranged perpendicularly with respect to each other.

14. Method according to one of claims 10 to 13, **characterised in that** the probe (10) is dimensioned in such a way that it can be inserted into a hollow space (30) with a diameter between 2 mm and 100 mm, in particular between 2 mm and 10 mm.

15. Method according to one of claims 10 to 14, **characterised in that** the first and the second magnetic-field sensor (14, 16) are GMR sensors - giant magnetoresistance sensor - or AMR sensors - anisotropic magnetoresistance sensor.

16. Method according to one of claims 10 to 15, **characterised in that** the probe (10) is rotated within the hollow space (30).

17. Use of a probe according to one of claims 1 to 9 or a method according to one of claims 10 to 16 for the detection of foreign-material accumulations and inclusions in bores in components of aircraft engines, in particular in compressor and turbine components.

18. Use of a probe according to claim 17, **characterised in that** the foreign-material accumulations and inclusions are spalled portions from boring tools made from ferromagnetic materials.

## Revendications

1. Sonde pour un procédé de mesure d'aimantation rémanente configurée pour détecter des dépôts et des inclusions de matières externes dans des creux, les creux (30) étant configurés dans une matière non ferromagnétique (32) et les dépôts et les inclusions de matières externes étant constitués d'une matière ferromagnétique, la sonde (10) présentant au moins un détecteur de champ magnétique (14, 16) et comprenant un premier et un deuxième aimant (18, 20), les aimants (18, 20) étant configurés dans un sens d'introduction dans le creux (30) devant au moins un capteur de champ magnétique (14, 16) et étaient disposés l'un par rapport à l'autre de manière que leurs axes polaires (22, 24) ne soient pas parallèles entre eux et au moins un détecteur de champ magnétique (14, 16) étant configuré pour mesurer les signatures des champs magnétiques des dépôts et inclusions de matières externes mesurables en tant que rémanence magnétique.

2. Sonde selon la revendication 1,
**caractérisée en ce que**
le détecteur de champ magnétique (14, 16) et les aimants (18, 20) sont disposés sur un élément de base (12).

3. Sonde selon la revendication 1 ou la revendication 2,
**caractérisée en ce que**
la sonde (10) présente un premier et un deuxième détecteur de champ magnétique (14, 16), le premier détecteur de champ magnétique (14) étant configuré pour détecter une rémanence magnétique provoquée par le premier aimant (18) et le deuxième détecteur de champ magnétique (16) pour détecter une rémanence magnétique provoquée par le deuxième aimant (20).

4. Sonde selon la revendication 3,
**caractérisée en ce que**
le premier aimant (18) est disposé entre le premier détecteur de champ magnétique (14) et le deuxième détecteur de champ magnétique (16) et le deuxième aimant (20) dans le sens d'introduction de la sonde (10) dans le creux (38) devant le deuxième détecteur de champ magnétique (16).

5. Sonde selon l'une quelconque des revendications précédentes,
**caractérisée en ce que**
la sonde (10) est réalisée de telle façon que les axes polaires (22, 24) du premier et du deuxième aimant (18, 20) sont perpendiculaires entre eux.

6. Sonde selon l'une quelconque des revendications précédentes,
**caractérisée en ce qu'**
elle peut être introduite dans des creux (30) d'un diamètre compris entre 2 et 100 mm, en particulier entre 2 et 10 mm.

7. Sonde selon l'une quelconque des revendications précédentes,
**caractérisée en ce que**
le premier et le deuxième détecteur de champ magnétique (14, 16) sont des détecteurs GMR, détecteurs à magnétorésistance géante, ou des détecteurs AMR, détecteurs à magnétorésistance anisotropique.

8. Sonde selon l'une quelconque des revendications précédentes,
**caractérisée en ce que**
le ou les détecteurs de champ magnétique (14, 16) sont reliés à un analyseur.

9. Sonde selon l'une quelconque des revendications précédentes,
**caractérisée en ce que**
la matière non ferromagnétique (32) est un alliage à base de nickel ou de Ti et les dépôts et inclusions de matières externes ferromagnétiques sont constitués de métal dur, en particulier de carbure de tungstène.

10. Procédé de détection de dépôts et inclusions de matières externes dans des creux comportant les étapes suivantes :
a) Introduction d'une sonde (10) dans un creux (30) d'une matière non ferromagnétique (32), la sonde (10) comprenant au moins un détecteur de champ magnétique (14, 16) et au moins un premier et un deuxième aimant (18, 20), les aimants (18, 20) étant configurés dans le sens d'introduction dans le creux (30) devant au moins un détecteur de champ magnétique (14, 16) et disposés l'un par rapport à l'autre de telle façon que leurs axes polaires (22, 24) ne sont pas parallèles entre eux ;
b) Magnétisation de dépôts et inclusions de matières externes constituées d'une matière ferromagnétique au moyen des aimants (18, 20) ;
c) Mesure des signatures des champs magnétiques des dépôts et inclusions de matières externes provoquées par la magnétisation et mesurables en tant que rémanence magnétique au moyen du détecteur de champ magnétique (14, 16) après un nouveau passage des aimants (18, 20) ; et
d) Analyse des résultats des mesures du champ magnétique et présentation du nombre et de la position des dépôts et inclusions de matières externes dans le creux (30).

11. Procédé selon la revendication 10,
**caractérisé en ce que**
la sonde (10) présente un premier et un deuxième détecteur de champ magnétique (14, 16), le premier détecteur de champ magnétique (14) étant configuré pour détecter une rémanence magnétique provoquée par le premier aimant (18) et le deuxième détecteur de champ magnétique (16) pour détecter une deuxième rémanence magnétique provoquée par le deuxième aimant (20).

12. Procédé selon la revendication 11, **caractérisé en ce que**
le premier aimant (18) est disposé entre le premier détecteur de champ magnétique (14) et le deuxième détecteur de champ magnétique (16), et le deuxième aimant (20) dans le sens d'introduction de la sonde (10) dans le creux (38) devant le deuxième détecteur de champ magnétique (16).

13. Procédé selon l'une quelconque des revendications 10 à 12,
**caractérisé en ce que**
les axes polaires (22, 24) du premier et du deuxième aimant (18, 20) sont perpendiculaires entre eux.

14. Procédé selon l'une quelconque des revendications 10 à 13,
**caractérisé en ce que**
la sonde (10) est dimensionnée de façon à pouvoir être introduite dans un creux (30) d'un diamètre compris entre 2 et 100 mm, en particulier entre 2 et 10 mm.

15. Procédé selon l'une quelconque des revendications 10 à 14,
**caractérisé en ce que**
le premier et le deuxième détecteur de champ magnétique (14, 16) sont des détecteurs GMR, détecteurs à magnétorésistance géante, ou des détecteurs AMR, détecteurs à magnétorésistance anisotropique.

16. Procédé selon l'une quelconque des revendications 10 à 15,
**caractérisé en ce qu'**
on tourne la sonde (10) à l'intérieur du creux (30).

17. Utilisation d'une sonde selon l'une quelconque des revendications 1 à 9 ou d'un procédé selon l'une quelconque des revendications 10 à 16 pour détecter des dépôts et des inclusions de matières externes dans des alésages pratiqués dans des composants de groupes motopropulseurs, en particulier dans des composants de compresseurs et de turbines.

18. Utilisation d'une sonde selon la revendication 17,
**caractérisée en ce que** les dépôts et inclusions externes sont des éclats d'outils d'alésage en matières ferromagnétiques.
